# EUROPEAN PATENT APPLICATION

(11) **EP 3 018 825 A1**
(43) Date of publication of application: **11.05.2016**
(21) Application number: 14192583.4
(22) Date of filing: 10.11.2014
(51) Int. Cl.: H03K 17/96, G06F 3/01, G06F 3/043

(54) **Piezoelectric sensor, apparatus and method for simultaneously generating a tactile signal and an acoustic signal**

(71) Applicant: Aito Interactive Oy, 02130 Espoo (FI)
(72) Inventor: Keski-Jaskari, Turo, 01340 Vantaa (FI)
(74) Representative: Väisänen, Olli Jaakko

(57) **Abstract**

A piezoelectric sensor (2) comprises
at least one piezoelectric element (20; 20, I; 20, II) arranged so that it is bendable to produce an electric signal (31, PZ, PZF1; PZF2, PZ2), at least one drive unit (1101) configured to drive the at least one piezoelectric element (20; 20, I; 20, II) to make it vibrate by changing a drive voltage (PZ; PZ1; PZ2) over the piezoelectric element (20; 20, I; 20, II), and at least one microcontroller (26) that is configured:
i) to read electric signals (PZF1; PZF2) indicating bending of said at least one piezoelectric element (20; 20, I; 20, II), and also
ii) to operate the drive unit (1101) on said at least one piezoelectric element (20; 20, 1; 20, II).

The at least one microcontroller (26) is configured, during an interval, to operate the drive unit (1101) on said at least one piezoelectric element (20; 20, I; 20, II) by generating haptic drive control signals (DRVN, DRVP, DRVEN; DRVEN2, DRVP, DRVEN1, DRVN) and acoustic drive control signals (DRVN, DRVP, DRVEN; DRVEN2, DRVP, DRVEN1, DRVN), the acoustic drive control signals (DRVN, DRVP, DRVEN; DRVEN2, DRVP, DRVEN1, DRVN) having a higher frequency but shorter duration than the haptic drive control signals (DRVN, DRVP, DRVEN; DRVEN2, DRVP, DRVEN1, DRVN).

## Description

### Field of the invention

The invention relates to piezoelectric input sensors and to devices in which piezoelectric sensors are used.

### Background art

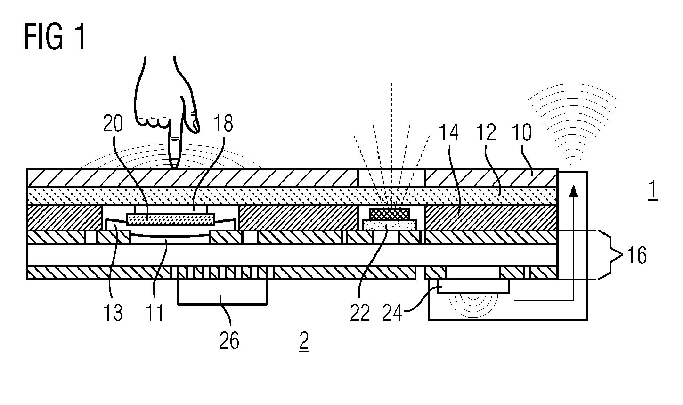

European patent application of the present applicant published under publication number EP 2 770 638 A1 (the contents of which are incorporated herein by reference) -hereinafter the '638 publication- describes a piezoelectric switch circuit having at least one piezoelectric sensor element. FIG 1 thereof has been redrawn as FIG 1 of the present application and illustrates an apparatus 1 having a device surface 10 that functions as overlay to the piezoelectric sensor 2. The piezoelectric sensor 2 comprises a piezoelectric switch circuit having at least two piezoelectric sensor elements 20.

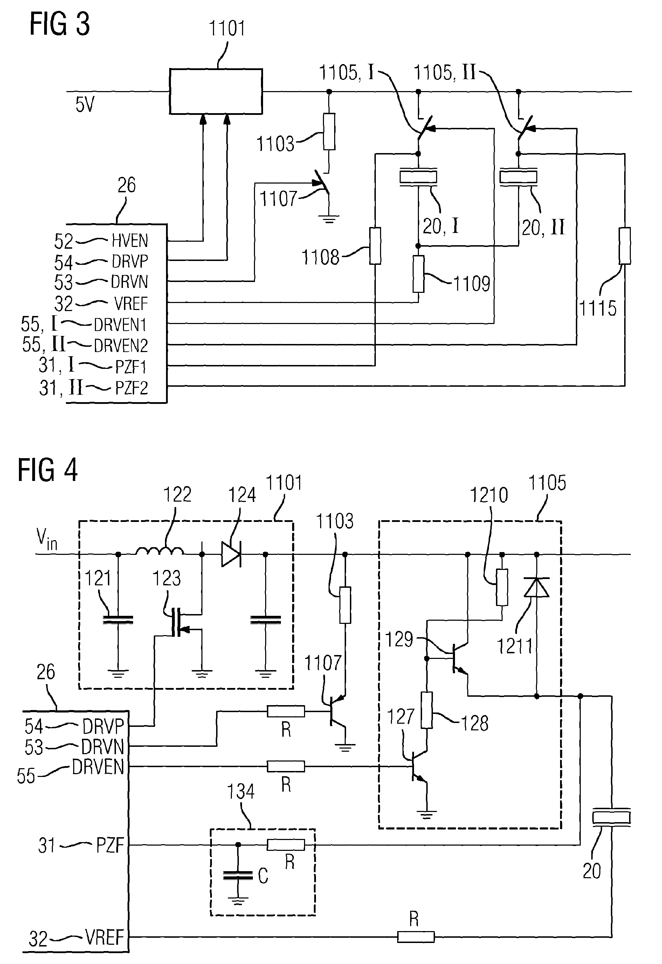

Furthermore, FIG 10, 11 and 12 of the `638 publication have been redrawn as FIG 3, 4 and 8 of the present application.

The piezoelectric sensor elements of the piezoelectric switch circuit of the '638 publication and also that shown in FIG 1 may be used not only to detect a signal resulting from bending of the piezoelectric sensor element due to it being subject to a force that results from pressure or force exerted (such as by a human finger) on the device surface to which the piezoelectric sensor element has been attached from below, but also to produce a haptic signal that can be sensed (such as by the human finger) through the surface.

### Objective of the invention

An objective of the invention is to make the piezoelectric sensors more versatile. This objective can be met with the piezoelectric sensor according to independent claim 1, with the apparatus according to independent claim 16, and with the parallel method claim 16.

Another objective of the invention is to improve the reliability of giving user feedback to user input that is obtained from bending of a piezoelectric sensor element. This objective can be met with any one of the dependent claims 8, 9 and 10.

A still further objective is to simplify the circuit design of a piezoelectric sensor that is capable of producing haptic and acoustic signals with at least one piezoelectric sensor element. This objective can be met with the piezoelectric sensor according to claim 15.

The dependent claims describe advantageous aspects of the piezoelectric sensor.

### Advantages of the invention

The piezoelectric sensor comprises at least one piezoelectric element arranged so that it is bendable to produce an electric signal, at least one drive unit configured to drive the at least one piezoelectric element to make it vibrate by changing a drive voltage over the piezoelectric element. The piezoelectric sensor further comprises at least one microcontroller configured: i) to read electric signals indicating bending of said at least one piezoelectric element, and also ii) to operate the drive unit on said at least one piezoelectric element. The at least one microcontroller is further configured, during an interval, to operate the drive unit on said at least one piezoelectric element by generating haptic drive control signals and acoustic drive control signals, the acoustic drive control signals having a higher frequency but shorter duration than the haptic drive control signals.

The versatility of the piezoelectric sensor can be improved by using the at least one piezoelectric sensor element not only for producing a haptic signal but also an audio signal. This will be possible by suitably configurating the microcontroller while, basically, no other modifications to the circuit disclosed in the '638 publication will be necessary.

Preferably, the microcontroller is configured to operate the haptic drive control signals and the acoustic drive control on the same piezoelectric element. The circuitry for doing so can be kept relatively simple if the haptic drive control signals and the acoustic drive control signals are superposed to form a combined haptic-acoustic drive control signal.

Alternatively or in addition, the microcontroller may be configured to operate the haptic drive control signals and the acoustic drive control signals on different piezoelectric elements. In the case that there are more than one piezoelectric sensor element, in this manner the piezoelectric sensor element(s) that is/are used for generating haptic signal and/or acoustic signal can be chosen.

The microcontroller may be configured to generate said haptic drive control signals and said acoustic drive control signals simultaneously during the interval. This enables the verstatility of the piezoelectric sensor so that both audio signal and a haptic signal can be generated simultaneously by using at least one piezoelectric sensor element.

If the microcontroller is configured to generate haptic drive control signals and/or acoustic drive control signals in response to detecting an electric signal indicating that at least one piezoelectric element is being bent or has been bent, the generation of haptic signals and/or acoustic signals by the at least one piezoelectric sensor element can be made reactive to operating the piezoelectric sensor.

In this case, the microcontroller may be configured to generate haptic drive control signals and/or acoustic drive control signals in response to detecting an electric signal indicating that at least one piezoelectric element is being bent or has been bent in such a manner that a defined bending threshold is being exceeded or is being undercut. This enables that the generation of the haptic signal and/or acoustic signal by the at least one piezoelectric sensor element can be made only when a specific condition is fulfilled. This can be made even better when the bending threshold is adjustable in the microcontroller. And there may be a number of bending thresholds in the microcontroller for all or some of the at least one piezoelectric sensor element.

The defined bending threshold may be so chosen that it indicates that a piezoelectric element is bottoming or about to bottom. For the definition of the term "bottoming" we refer to the definition in the detailed description .

The defined bending threshold may be so chosen that it indicates that a piezoelectric element is being bent but not sufficiently, indicating that the contact force on a surface that functions as the overlay for the piezoelectric sensor causing the bending of the at least one piezoelectric element, is not sufficiently strong so that the vibration of the at least one piezoelectric element were usable as haptic feedback. In a such case, the piezoelectric sensor is configured to generate audio feedback, preferably via the at least one piezoelectric element. If the user of the piezoelectric sensor stops exerting pressure by his/her finger, it would make little or no sense to produce a haptic signal since most probably the user's finger will be no longer be present to detect the haptic signal. But the user may not have gone too far away and therefore might hear the acoustic signal.

The microcontroller may be configured to adjust the haptic drive control signals and/or the acoustic drive control signals in such a manner that the frequency and/or amplitude of the drive voltage is controllable. This enables better control possibilities over the piezoelectric sensor, in particular if the microcontroller is configured to control the frequency and/or amplitude of the drive voltage in response to state information of the piezoelectric sensor.

The state information may indicate whether a bending threshold on a piezoelectric element is being exceeded, is being undercut, and/or whether bending of a piezoelectric element is between a defined range.

Advantageously, the microcontroller may be configured: i) upon exceeding or undercutting a first bending threshold, to start generating audio drive signal for producing audio feedback signal having a first sound level and/or frequency, and upon exceeding a second bending threshold that is higher than the first bending threshold, to start generating haptic drive signal for producing haptic feedback signal; and/or ii) to use different thresholds with dedicated feedback signalling for generating both audio signal and vibration signal as modulation functions in respect to bending levels of the at least one piezoelectric sensor element being responsive to pressure or force exerted on the device surface that functions as overlay to the piezoelectric sensor.

If the microcontroller is configured to operate a charge emptying switch with the acoustic drive control signal to form acoustic drive signal of said at least one piezoelectric sensor element at activation points as deformations of the haptic drive signal to generate audible vibration of said at least one piezoelectric element in addition to haptic vibration of said at least one piezoelectric sensor element, the acoustic drive signal for the piezoelectric sensor element or elements can be implemented with a relatively simple circuit design.

The apparatus according to the third aspect of the invention comprises a piezoelectric sensor according to the first aspect of the invention. The apparatus comprises a surface configured to act as overlay to the piezoelectric sensor in such a manner that pressing on the surface, such as by the finger, causes at least one piezoelectric element to bend and that vibration emitted by the at least one piezoelectric element in response to the haptic drive control signals cause tactile vibration of the surface.

The method for simultaneously generating a tactile signal and an acoustic signal with at least one piezoelectric sensor that comprises: a) at least one piezoelectric element arranged so that it is bendable to produce an electric signal, b) at least one drive unit configured to drive the at least one piezoelectric element to make it vibrate by changing a drive voltage over the piezoelectric sensor element, and c) at least one microcontroller configured: ci) to read electric signals indicating bending of said at least one piezoelectric element, and also cii) to operate the drive unit on said at least one piezoelectric element comprises the step of: during an interval, the drive unit is operated on said at least one piezoelectric element by generating haptic drive control signals and acoustic drive control signals in the microcontroller, the acoustic drive control signals having a higher frequency but shorter duration than the haptic drive control signals, most preferably so that the acoustic drive control signals are used to up- and down-ramp a haptic drive signal over said at least one piezoelectric element in such a manner that an acoustic signal results from deformations in the haptic drive signal. The method can be used with the piezoelectric sensors and with the apparatus according to the invention.

### Brief description of the drawings

In the following, the invention is described in more detail with the examples shown in FIG 2 and in FIG 5 to 7 of the accompanying drawings, of which:
- FIG 1: illustrates an apparatus with a piezoelectric sensor that has been arranged below the device surface;
- FIG 2: is a flow diagram illustrating the sequence of following the pressure exerted by the user to the piezoelectric sensor element 20, and the respective reactions by the microcontroller 26 using the respective circuitry and piezoelectric sensor element(s) 20, and/or separate buzzer 24;
- FIG 3: is a simplified circuit showing certain components of the piezoelectric circuitry;
- FIG 4: is a more detailed circuit than that shown in FIG 3, showing also details of the boost converter in more detail;
- FIG 5: is a timing diagram of generation of haptics and audio using the same piezoelectric sensor element 20 through the circuitry shown in FIG 3, 4, and 8;
- FIG 6: is a timing diagram of generation of haptics and audio using the same piezoelectric sensor element 20 through the circuitry shown in FIG 3, 4 and 8 from both rising and falling edge of the haptic pulse;
- FIG 7: is a timing diagram of generation of haptics and audio using one piezoelectric sensor element 20 as haptic output and another piezoelectric sensor element 20 for audio output, through the circuitry shown in FIG 3, 4, and 8;
- FIG 8: is a detailed circuit diagram of a practical example showing the components of the piezoelectric sensor.

Same reference numerals refer to same or similar structural elements in all FIG.

### Detailed description

The repeating of the detailed description of the contents of FIG 1, 3, 4 and 8 is omitted for the sake of conciseness. The reader is referred to consult the '638 publication where the way of functioning of each component and the manner of operation of the piezoelectric sensor 2 is described in more detail.

The present inventors have found out that interleaving audio with haptic feedback from same or neighboring piezoelectric sensor element 20, offers wider operational window for haptic feedback from same or neighboring piezoelectric sensor element 20. When pressure in sensor is too low (indicating that no finger is pressing the device surface 10) or too high to transfer the haptic vibration, audio feedback can be provided.

Furthermore, the present inventors have found out that there is an optimal pressure between user's finger and the piezo stack to transfer maximal vibration energy from piezoelectric sensor element 20 to user's finger. However, when force or pressure exerted to the device surface 10 by the finger and thereto also to the piezoelectric sensor element 20 increases, the characteristics and optimal window of operation of the vibration transfer will be impaired.

One particular problem emerges when the user uses so much force that the piezoelectric sensor element 20 is bent so much that it, while flexing, either touches the underlying material, or the mechanical stack as a whole otherwise reaches the state in which it does not flex enough anymore. This is what we call bottoming of the piezoelectric sensor element 20.

Thus when the user presses on piezoelectric sensor element 20 with high enough force, piezoelectric sensor element 20 will eventually reach a state where it cannot move enough anymore, with any reasonable energy, to give effective haptic feedback. Already before reaching this state, the resonant frequency of the system may be outside of the optimal operating window so much that driving of haptic pulses is not anymore as feasible as it could be, or the user experience will be disturbed by the undesired side effects caused by the altered operating window.

Piezoelectric sensor 2 comprises at least one piezoelectric sensor element 20 having at least two terminals, and a microcontroller 26 electrically connected to said at least one piezoelectric sensor element 20 and configured to read a signal PZF (cf. FIG 4) or PZF1, PZF2 (cf. FIG 3, if there are two piezoelectric sensor elements 20, I and 20, II) indicative of the voltage between the two terminals, and to output at least one output signal in response to the signal read, indicating that the piezoelectric sensor element is being pressed or has been pressed by a finger.

The microcontroller 26 may be configured to continuously sample the signal indicative of the voltage changes PZF, PZF1, PZF2, at piezoelectric sensor element 20, or generally, PZF<i> for any number of piezoelectric sensor elements 20, indicative of the respective pressure force changes by a finger on the piezoelectric sensor element 20. The microcontroller 26 may be configured to react on the changes in many advantageous ways. When the piezoelectric sensor 2 is also configured to produce a signal to the at least one piezoelectric sensor element 20 to make it vibrate, the characteristics of the vibration can be altered in relation to the measured pressure.

In the manner disclosed in the present patent application, microcontroller 26 may alter the vibration to:
- provide audio feedback when piezoelectric sensor 20 element is mechanically out of its optimal operation window or "bottomed" by the pressure exerted by the finger, and not more able to operate in haptic range;
- modulate feedbacks according to the use case, or user properties, or overlay (device surface 10) and mechanical stack properties that provide the overall experience of intuitive and pleasant feedback;
- transition between haptics and audio seamlessly using the same piezoelectric sensor elements 20 according to use case, user preferences, and measured and/or externally configured environmental parameters;
- secure optimal haptic vibration energy transfer in timing the haptic output to match optimal energy transfer window between vibrating surface and finger;
- output feedback signal (audio) from another and multiple piezoelectric elements 20, when the piezoelectric sensor 2 comprises a plurality of piezoelectric sensor elements 20;
- alter the shape and characteristics of individual haptic pulses even without going to audio frequency ranges; and/or
- play feedback in predetermined patterns disconnected to pressing pressure.

As the haptic and audio signals are proven by scientific research to mix in very low levels in the human brain, gradual shifting towards the audio frequencies can even feel like the haptic would still be coming in the higher force levels, provided that in the beginning there was haptics provided, and indeed felt by the user. This is however also largely depending on the "user specific" parameters, including but not limited to age, physical condition, gender, skin and muscle properties, etc.

It is to be understood that microcontroller 26 may be configured to gradually generate a joint control signal, in which the superposition of haptic control signal and audio control signal gradually shifts towards audio frequencies.

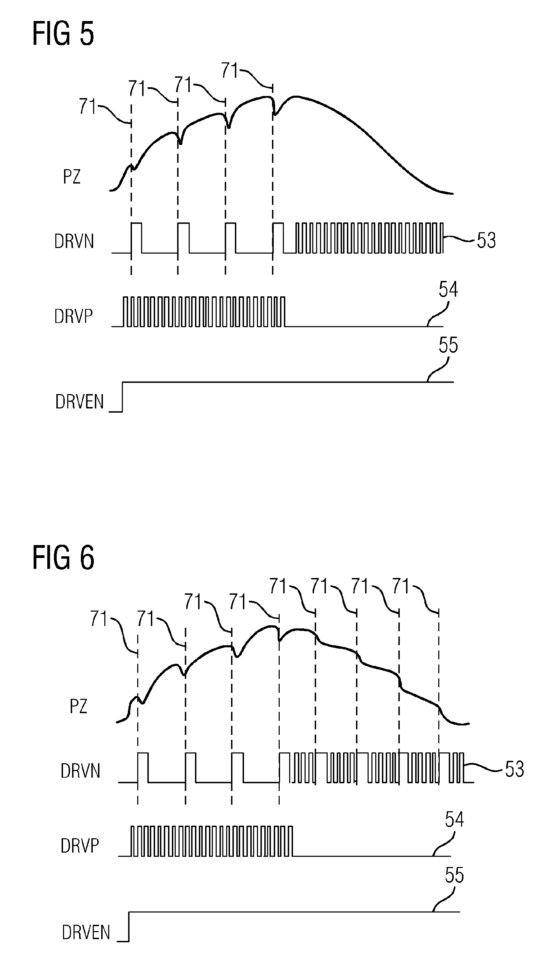

The piezoelectric device 2 comprises in addition to one ore more piezoelectric sensor elements 20 also microcontroller 26. The at leat one piezoelectric sensor element 20 is arranged below the device surface 10 of an apparatus 1 in such a manner that, when the device surface 10 is being pressed with a finger, the at least one piezoelectric sensor element 20 is bent, generating a voltage PZF (or PZ1, PZ2, or PZ<i> as explained above) over the at least one piezoelectric sensor element 20. Microcontroller 26 is configured to read the voltage and to output signals DRVEN, transistor drive signal (DRVN) 53 and boost drive signal (DRVP) 54 (cf. FIG 5, 6) in response to the voltage, after having determined that the measured voltage from the piezoelectric sensor element 20 is stable enough (i.e. that its stability fulfills a prefedined criteria).

In the circuitry shown in FIG 3, 4 and 8, signals DRVP 54 and DRVN 53 are in addition used to control the voltage of the boost converter 1101 and charge emptying switch transistor 1107, respectively, by the microcontroller 26, to create haptic effects for the user, by using the same piezoelectric sensor element 20 that is being used to sense force or pressure.

Signal DRVP 54 is for switching the field effect transistor coupled with coil and diode, essentially forming a typical boost converter 1101 circuit. Signal DRVN 53 is then used to open and close a transistor 1107 that drains the voltage from charged piezoelectric sensor elements 20 through a load resistor 1103, using transistor 1107 as a switch.

The piezoelectric sensor 2 comprises microcontroller 26, a two-layer printed circuit board 16 (or any other suitable printed circuit board), in which there is recess 11 on top of which metal plate 13 has been attached. On metal plate 13 there is piezoelectric sensor element 20. On top of piezoelectric sensor element 20 there is conductive adhesive. Conductive foil 12 is arranged between device cover 10 and double sided adhesive 14 attached to the upper layer of the printed circuit board 18.

Piezoelectric sensor 2 may additionally comprise at least one LED 22 that may be soldered on the printed circuit board 18, and at least one buzzer 24.

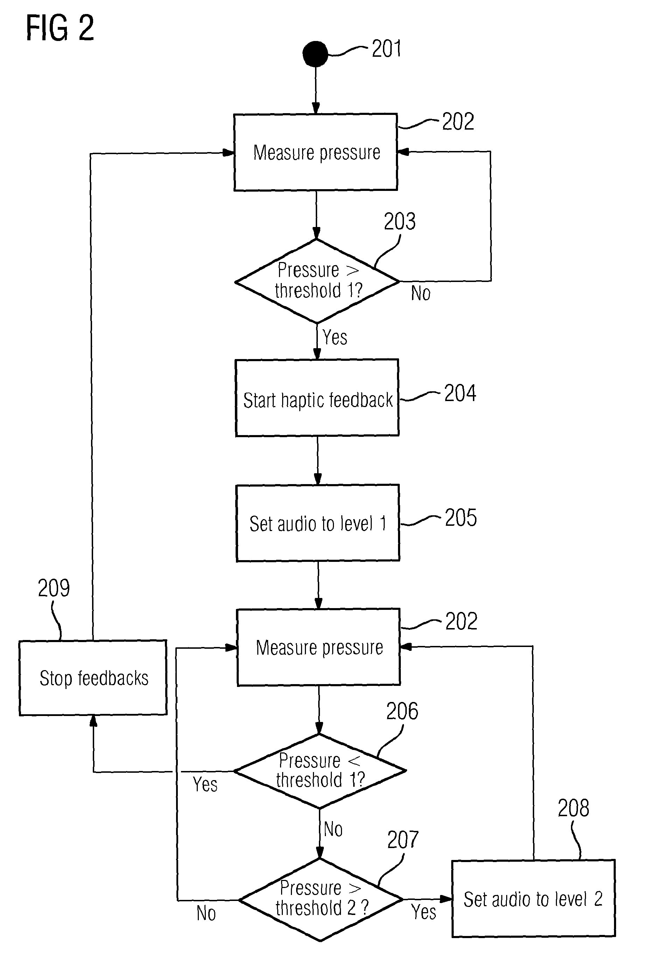

FIG 2 is a flow diagram illustrating the sequence executed by microcontroller 26 to modulate haptic and audio outputs for the user in relation to the measured force or pressure on the piezoelectric sensor element 20, such as exerted by the user's finger. Measurement is achieved by the microcontroller 26 by comparing the analog input signal PZF 31 at microcontroller input channel to VREF signal 32. VREF signal 32 is preferably artificially generated, such as by internal reference voltage generator in microcontroller 26, external voltage reference generator, or derived by a typical voltage divider circuit from the operating voltage and is representative of the voltage between piezo element connection PZ 21 and piezo common signal 23.

In particular, after beginning from step 201, the execution in microcontroller 26 remains in a loop at steps 202 and 203, as long as the measured and interpreted force/pressure does not exceed set threshold value. After the force/pressure exceeded the threshold value, haptic feedback output is set active (step 204), along with selected modulated audio level 1 (step 205), of which the latter can as well be no audio, as any other level of audio, depending on the use case in question. Next, microcontroller 26 continues to run in state 202, measuring the force/pressure, but now comparing whether the result went under threshold 1 (step 206), or over another threshold level (threshold 2). Going under threshold 1 results in stopping both haptic and audio feedbacks (step 209), and going over threshold 2 results in setting the new audio level 2, which can as well be lower, higher, or even the same as audio level 1, depending on the use case, and then returning to the loop, measuring the force/pressure and comparing with thresholds.

In practical applications of the piezoelectric sensor 2 there may be any number of measurement thresholds (1, 2, ...), as well as audio levels (1, 2, ...), or the control may as well be continuous through a set of algorithms in microcontroller 26.

FIG 3 is a simplified circuit showing certain components of piezoelectric sensor 2.

When microcontroller 26 via signal DRVN 53 closes switch 1107, first piezoelectric sensor elements 20, I and second piezoelectric sensor elements 20, II are returned to initial state by draining the charge through a load resistor 1103. After this, microcontroller 26 opens switch 1107.

First piezoelectric sensor element 20, I is connected through resistors 1108, 1109 between the VREF signal 32 and PZF1 (analog input signal 31, I) at respective channels of microcontroller 26. Second piezoelectric sensor element 20, II is connected through resistors 1115, 1109 between the VREF signal 32 and PZF2 (analog input signal 31, II) at respective channels of microcontroller 26.

In microcontroller 26, PZF1, PZF2 (analog input signals 31, I and 31, II from respective channels) lead to the first and second analog-to-digital-converter channel. With this setup, the signal indicating voltage over first piezoelectric sensor element 20, I and second piezoelectric sensor element 20, II can be converted to digital signals and processed by microcontroller 26.

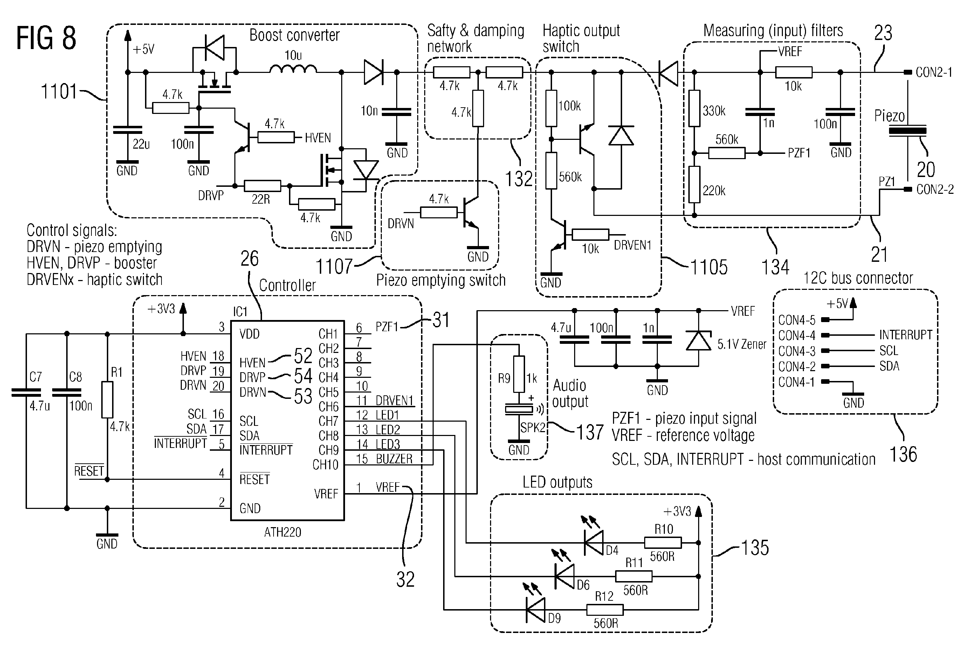

A voltage which may be 5 Volt DC, is provided to boost converter 1101. The purpose of boost converter 1101 is to raise the operating voltage across piezoelectric sensor element 20 up to 400 Volts to enable it to vibrate enough the device 1 surface 10 for tactile signaling. This is achieved via a typical boost (or "step-up") converter 1101 circuit, consisting of regular coil, FET, diode and capacitors. More details of the circuit are shown in FIG 4 and FIG 8.

When microcontroller 26 via drive enable signal (DRVEN1) 55, I closes switch 1105, I, and signal HVEN 52 is active and signal DRVP 54 is pulsed, boost converter 1101 sets a voltage over first piezoelectric sensor element 20, I which makes it vibrate.

When microcontroller 26 via drive enable signal (DRVEN2) 55, II closes switch 1105, II, and signal HVEN 52 is active and drive enable signal 54 is pulsed, boost converter 1101 sets a voltage over sets piezoelectric sensor element 20, II which makes it vibrate.

FIG 4 is a more detailed circuit than that shown in FIG 3, showing certain details of the boost converter in more detail. In particular, in FIG 8 we show that a boost converter 1101 circuit comprises or consists of input capacitor 121, coil 122, transistor switch 123 (typically fast N-type MOSFET), output diode 124, and the output capacitor. In the scope of the invention, the at least one piezoelectric sensor element 20 also functions as output capacitors for boost converter 1101. If there is a plurality of piezoelectric sensor elements 20 (I, II, ...), all or some of them can function as output capacitors for boost converter 1101.

Step-up conversion of the voltage bases on the tendency of the inductor (coil 122) to resist changes in current passing through it. Boost converter 1101 has two states, in one of them transistor switch 123 is closed, connecting the end of coil 122 to ground, and causing current to flow into coil 122 from the power supply signal Vin. Current flows in as long as transistor switch 123 is closed, and energy gets stored into magnetic field induced by coil 122. In the second state of the circuit, transistor switch 123 is opened, and the energy stored in coil 122 gets a new path to be released through the diode 124, eventually getting stored to the output capacitor, and in this case also to the at least one piezoelectric sensor element 20. Microcontroller 26 switches transistor switch 123 on and off so fast (typically in the range of hundreds of kHz) that coil 122 does not have time to fully discharge between the rapidly changing states of the boost converter 1101 circuit, hence building more and more voltage to the output capacitor(s). In the scope of piezoelectric sensor 2, the process of building the voltage by switching transistor switch 123 is also controlled by microcontroller 26 so that the rising edge of resulting voltage pulse gets a desired form, hence also shaping the haptic output pulse driven to the piezo through switch circuit 1105 formed using transistors 127 and 129. Similarly, the microcontroller 26 drives the emptying transistor 1107 rapidly on and off so that the falling edge of a haptic pulse is also shaped in a desired way. The desired shape may be reached by any typical engineering methods, as well by modelling and simulation, as by trial and error.

FIG 5 is a timing diagram illustrating the voltage over piezoelectric sensor element 20, when the signals 53, 54 and 55 in the circuit in FIG 3, 4, 8 are driven as shown in FIG 5 by the microcontroller 26. The high voltage generation switch signal HVEN 52 is always on during the process shown. In particular signal DRVEN 55 is at first driven to high state, to enable the haptic switch 1105, I. Then to form the rising edge of the haptic pulse into piezoelectric sensor element 20, boost converter 1101 is driven by rapidly altering the state of signal DRVP 54 typically in hundreds of kHz of range (frequency and voltage proportions are only indicative in the illustration). Then, the falling edge of haptic pulse of the voltage over the piezoelectric sensor element is created by shutting off boost converter 1101 by setting signal HVEN 52 to zero, and by rapidly altering the state of signal DRVN 53 to control the microcontroller 26 to empty the charge from the piezoelectric sensor element 20, through the emptying transistor 1107 and load resistor 1103.

In addition to the haptic pulse generation, signal DRVN 53 may be activated at a different frequency, namely in human audible frequencies, for example 2000Hz, i.e. intervals of 500 microseconds. As shown in FIG 5, each activation point 71 of signal DRVN 53 creates a dent in the piezo voltage at piezo element connection 21. When these dents are created in an audio frequency (or in audio frequencies), the resulting user experience will be audible sound modulated on top of the haptic signal, which in turn will still be felt on the user's finger. By altering signal DRVN 53 active periods, the strength of the audible effect (amplitude) can be varied, obviously with some expense to the resulting haptic feeling. These dents can be created (modulated) as well to the rising edges, as shown in the illustration, as to the falling edge, by keeping signal DRVN 53 steady for a while

If there is a plurality of piezoelectric sensor elements 20 (I, II, ...), signals DRVEN 55 (I, II, ...) can direct the haptic pulses and modulated audio outputs to respective piezoelectric sensor elements 20 (I, II, ...) through their respective switch circuits 1105 (I, II, ...), to either one at a time, or to multiple elements simultaneously.

FIG 6 is a timing diagram illustrating the voltage changes at the piezo element connection 21, representative of the voltage over piezoelectric sensor element 20, when signal DRVN 53, signal DRVP 54 and signal DRVEN 55 in the circuitry in FIG 3, 4, 8 are driven as illustrated in FIG 6 by microcontroller 26. Other signaling can be made similarly as in the case illustrated in FIG 5, but additionally signal DRVN 53 may be used to create 'dents' to voltage PZ over piezoelectric sensor element 20 during the rapid pulsation of signal DRVN 53 to empty the high voltage from the piezoelectric sensor element 20. Hence creating audible frequency modulated on top of the falling edge of the haptic pulse with inherently lower frequency, as seen on the shape of voltage PZ oer the piezoelectric sensor element 20 as illustrated in FIG 6.

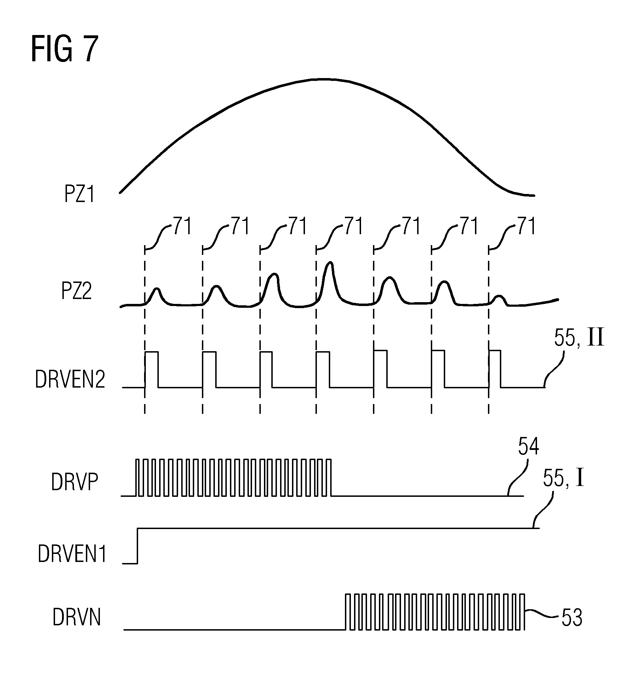

FIG 7 is a timing diagram illustrating voltage PZ1 over a first piezoelectric sensor element 20, I, and voltage PZ2 over a second piezoelectric sensor element 20, II that is driven through another parallel haptic output switch element 1105, II, different than the switch element 1105, I that drives the piezoelectric sensor element 20, I.

Output signals are again, as in FIG 5 and FIG 6, described as the function of driving signal DRVN 53 and signal DRVP 54, and in this case two separate drive enable signals (DRVEN) 55, I, II (DRVEN1 and DRVEN2) in the circuitry in FIG 3, 4, 8, by the microcontroller 26. In practical application opening signal DRVEN2 55, II also affects the voltage over the as the piezoelectric sensor element 20, I shares with piezoelectric sensor element 20, II the common high voltage wire between boost converter 1101 and the respective switches 1105 (I, II, ...) for different channels, in the circuit of FIG 3, 4, 8. This effect is however smaller than the generated voltage changes, hence audio, in the piezo element connection 21, II.

FIG 8 is a detailed circuit diagram showing the components of piezoelectric sensor 2. In addition to circuits already described in FIG 3 and 4, in FIG 8 the structure of safety & damping network 132, I²C bus connector 136, audio output 137 and LED outputs 135 are shown in more detail.

In other words, the signal DRVN 53 is additionally used to modulate audio on top of the haptic signal, based on the changes in the measured pressure, measured by the microcontroller 26 as a voltage difference between analog input signals on channels 31 (I, II, ...) and VREF signal 32. As the two signals are individually in full control of the microcontroller 26, it is possible to utilize signal DRVP 54 normally as boost converter driver, but also during rising the voltage, signal DRVN 53 can be periodically activated for short periods to create another frequency on top of the haptic pulse frequency. As haptic pulses are typically at lower end of the audio spectrum (up to 250Hz), the mentioned signal DRVN 53 modulation can be done at much higher range, e.g. 1000Hz or 2000Hz, up to the 20kHz audible range of human users. Still even the highest possible tones are lower than typical boost converter driving frequencies, at which signal DRVP 54 needs to switch, at hundreds of kilohertz range, hence forming a balanced total solution where different frequency ranges do not need to overlap with each other.

To overcome the problem of operating point of driving the piezoelectric sensor element 20 going off the range, while user presses with high pressure force, we need to note that even if the system is off the operating window, or even mechanically bottomed" for relatively low haptic frequencies, it may still be operable in audio frequency range, and typically also is.

In the present invention the user's pressing force is periodically measured during the whole press cycle, using the circuitry described in FIG 3, 4, 8 by the microcontroller 26, in particular the voltage between analog input 31 and VREF signal 32, indicative to the voltage over piezoelectric sensor element 20. The information of the measured pressure is then used to modulate the driving of the boost converter 1101 according to the flow chart 200 of FIG 2, using the signals and driving patterns presented in FIG 3 to 8. In particular, signal DRVN 53 can be activated and deactivated periodically so, that the frequency corresponds with that of the desired audio output frequency. Boost converter 1101 itself is continuously and in parallel operated separately with individual control through signal DRVP 54, by the microcontroller 26. In practical application the haptic pulse voltages also affect the resulting measured voltage seen by the microcontroller 26 as difference between analog input signal 31 and VREF signal 32, through the measuring (input) filters 134 of FIG 8, and thus the delay between individual haptic pulses may need to be limited, and/or any kind of compensation used to set the threshold values so that the previous haptic pulse's reminiscent charges are taken into account for the next measurement of the voltage between analog input signal at channel 31 and VREF signal 32, indicative of the voltage over the piezoelectric sensor element 20.

The audio modulation can be started at once after a threshold or other condition is reached, as described in flow chart 200 of FIG 2, as well as gradually by smoothly shifting from pure haptic output towards pure audio feedback, or from audio towards haptics, or with any other mix of the modulations. Technically the gradual shifting towards audio starts by switching the emptying transistor 1107 to conductive state by signal DRVN 53 at first for relatively short times, e.g. tens of microseconds, and then expanding the transistor conductive periods in relation to transistor 'closed' periods, while keeping the total cycle length, hence desired audio frequency of the switching constant. In other words using typical Pulse Width Modulated (PWM) signal amplitude control. In addition to or instead of altering the pulse width, the pulse frequency can also be altered to any desired direction. In addition also boost converter driving, i.e. signal DRVP 54 switching parameters can be altered during the gradual shift, to rise, lower, or otherwise change the haptic effect felt by the user's finger. Altering these also affects the created audio, as audio is modulated on top of the haptic wave. This relation is also known, as the circuitry and mechanical parameters are usually known, and in the full control by the one microcontroller 26, which in turn can still control the total user experience gained by driving all the separate signals, even with interlinks between modes, modalities, and signals.

When signal DRVN 53 is just switched on and off at the desired audio frequency, as in FIG 5, or similarly when drive enable signal (DRVEN2) 55, II is switched on and off as in FIG 7, it will in addition to the desired base audio frequency also generate higher audible frequencies, as the change in charge is so fast through the RC time constant of piezoelectric sensor element 20 and resistor 1103, or the RC time constant of piezoelectric sensor element 20 and safety and damping network 132 of FIG 8. To prevent unwanted higher frequencies, rising or falling edges in the modulated audio pulses may in practical solution be structured by another modulation: using Pulse Width Modulation (PWM) in tens of kilohertz range to drive signal DRVN 53 or any of the drive enable signals 55 (I, II, ...) as to shape the audio pulse so, that it gets a round, sine wave like shape, which mainly contains the desired audio frequency, hence creating such voltage change characteristics for respective piezoelectric sensor element(s) 20 (I, II, ...), that they output audible sound mainly at the desired frequency, on top of the haptic pulse when applicable.

The amount of the gradual shifting towards audio frequencies and audio driving can be done by comparing the measured pressure levels to for example pre-measured and/or pre-calculated table based on the known or estimated mechanical and electrical parameters of the user interface stack and related electronics, as in flow chart 200 of FIG 2 (called 'threshold' 1, 2, ...), or shifting towards audio can be made just using the relative changes in the pressure force, measured by the microcontroller 26 using the circuits described in FIG 3, 4, 8.

As the mixing process of the human brain tends to interpret higher frequencies heard during the press as sharper feedback, the method presented in this invention can in one embodiment also be used to alter the perceived sharpness of the haptic feedback by the user. I.e. creating a mainly haptic signal (for example sine wave at or below 250Hz) by the means of the boost converter 1101 driving by signal DRVP 54, and the emptying transistor 1107 driving by signal DRVN 53, as a carrier wave. On top of which additional cycling of signal DRVN 53 on and off creates the modulated signals that are mainly in audio frequencies. By altering the frequency and amplitude of the modulated audio signal creates a total effect of haptic signal + audio signal merging in the user's brain to one experience of haptic feeling, with different perceived amplitudes or different levels of sharpnesses, for example. When this is done in relation to the pressure force applied by the user and the changes on the said force, a wide variety of different experiences can be created for the user.

In another embodiment the sharpness of the press can also be varied in the opposite direction, i.e. beginning with sharper feedback (i.e. including more modulated audio frequencies, generated as described), and the gradually or step by step moving towards less audio feedback, while the user pressure increases. This acts to the opposite direction from the change that the finger induces to the user interface stack, i.e. changing the resonant frequency higher, and thus producing noisier, i.e. sharper feedback naturally with the increased finger pressure. When the generated sharpness decreases along with increased user pressure, the two phenomena effectively work against each other, and thus make the feedback feel more similar over the whole pressing cycle.

Also the whole pulse shape (in a pulse stream) as such can be varied according to the pressure force, by altering signal DRVP 54 and signal DRVN 53 driving parameters during the press, instead of another signal modulated over it using them both at the same time. Changes can be applied for example to amplitude or to frequency, or the overall shape (sine wave, triangular wave, square wave etc.), or using any combination of these all.

In another embodiment the audio can also be played out from another one or plurality of piezoelectric sensor elements 20 (I, II, ...), than the one piezoelectric sensor element 20 to where the finger pressure is applied, and to which the haptic pulses are driven using signals DRVN 53 and DRVP 54 by the microcontroller 26. Drive enable signal 55 (DRVEN) relating to the piezoelectric sensor 20 which is used for the haptic pulse, is kept active all the time, hence also keeping the related haptic output switch 1105 closed. In addition, during the rising and/or falling edge of the haptic pulse, the drive enable signals 55 (I, II, ...) of the other channel(s) selected for audio output are pulsed with the desired audio frequency, to cause the piezoelectric sensor elements 20 (I, II, ...) on those channels create audible audio frequency level output for the user.

In yet another embodiments the shifting back and forth to and from audio and haptic frequencies with modulation pulse shapes may also be done using a pre-determined sequence regardless the input pressure, programmed by any means to the control integrated circuit (in the integrated software, through a configuration bus, using an external EEPROM memory, etc.). These pre-determined patterns can also be used as plain output to the user, like signaling related to application events, or even just 'for fun'. And they can also be linked to an input event as pre-determined output pattern, without even measuring the force during the press.

By adding just some audio content to regular haptic feedback pulses by the means described in the present invention, it is also possible to convey different experiences even when the amount of audio is not changed over the key press. An example of this is making a plastic surface feel more metallic by adding higher pitch audio to the pulses. This follows from that people's brain subconsciously know that metal is usually stiffer material than plastic, hence it has higher resonant frequency. Thus when the feedback from the press comes with higher frequency, it can sound more metallic for the user.

The many features and advantages of the present invention are apparent from the written description. Further, since numerous modifications and changes will be readily apparent to those skilled in the art, the invention should not be limited to the exact construction and operation as illustrated and described. Hence, all suitable modifications and equivalents may be resorted to as falling within the scope of the invention.

In particular, the number of piezoelectric sensor elements 20 may be different from three. Furthermore, it is not necessary that each piezoelectric sensor element 20 is configured so that a haptic signal can be switched over it.

### List of reference numerals used:

- PZ,: voltage over piezoelectric sensor element
- PZ1, PZ2, PZ: <i>

- 1: apparatus (electric appliance, installation or gadget)
- 2: piezoelectric sensor
- 10: device surface
- 11: recess
- 12: conductive foil
- 13: metal plate
- 14: double-sided adhesive
- 16: two-layer printed circuit board
- 18: conductive adhesive
- 20: piezoelectric sensor element
- 21: piezo element connection
- 22: LED
- 23: piezo common
- 24: buzzer
- 26: microcontroller
- 31: analog input signal
- 32: voltage reference (VREF) signal
- 52: haptic/acoustic enable signal (HVEN)
- 53: transistor drive signal (DRVN)
- 54: boost drive signal (DRVP)
- 55: drive enable signal (DRVEN)
- 71: activation point
- 121: input capacitor
- 122: coil
- 123: transistor switch
- 124: diode
- 127: transistor
- 128: resistor
- 129: transistor
- 132: safety & damping network
- 134: measuring (input) filters
- 135: LED outputs
- 136: I²C bus connector
- 137: audio output
- 201: begin
- 202: measure pressure
- 203: test whether pressure greater than threshold 1
- 204: start haptic feedback
- 205: set audio to level 1
- 206: test whether pressure smaller than threshold 1
- 207: test whether pressure greater than threshold 2
- 208: set audio to level 2
- 209: stop feedbacks
- 1101: boost converter
- 1103: resistor
- 1105: haptic output switch
- 1107: transistor
- 1108: resistor
- 1109: resistor
- 1115: resistor
- 1210: resistor
- 1211: diode

## Claims

1. A piezoelectric sensor (2), **comprising:**
- at least one piezoelectric element (20; 20, I; 20, II) arranged so that it is bendable to produce an electric signal (31, PZ, PZ1, PZ2);
- at least one drive unit (1101) configured to drive the at least one piezoelectric element (20; 20, I; 20, II) to make it vibrate by changing a drive voltage (PZ; PZ1; PZ2) over the piezoelectric element (20; 20, I; 20, II); and
- at least one microcontroller (26) configured:
i) to read electric signals (PZF1; PZF2) indicating bending of said at least one piezoelectric element (20; 20, I; 20, II), and also
ii) to operate the drive unit (1101) on said at least one piezoelectric element (20; 20, I; 20, II) ;
and wherein:
the at least one microcontroller (26) is configured, during an interval, to operate the drive unit (1101) on said at least one piezoelectric element (20; 20, I; 20, II) by generating haptic drive control signals (DRVN, DRVP, DRVEN; DRVEN2, DRVP, DRVEN1, DRVN) and acoustic drive control signals (DRVN), the acoustic drive control signals (DRVN) having a higher frequency but shorter duration than the haptic drive control signals (DRVN).

2. The piezoelectric sensor (2) according to claim 1, **wherein:** the microcontroller (26) is configured to operate the haptic drive control signals (DRVN, DRVP, DRVEN; DRVEN2, DRVP, DRVEN1, DRVN) and the acoustic drive control signals (DRVN) on the same piezoelectric element (20; 20, I; 20, II).

3. The piezoelectric sensor (2) according to claim 2, **wherein:** the haptic drive control signals (DRVN, DRVP, DRVEN; DRVEN2, DRVP, DRVEN1, DRVN) and the acoustic drive control signals (DRVN) are superposed to form a combined haptic-acoustic drive control signal (PZ; PZ1, PZ2).

4. The piezoelectric sensor (2) according to any one of the preceding claims, **wherein:** the haptic drive control signals (DRVN, DRVP, DRVEN; DRVEN2, DRVP, DRVEN1, DRVN) and the acoustic drive control signals (DRVN) are formed as a single signal in the microcontroller (26).

5. The piezoelectric sensor (2) according to claim 1, **wherein:** the microcontroller (26) is configured to operate the haptic drive control signals (DRVN, DRVP, DRVEN; DRVEN2, DRVP, DRVEN1, DRVN) and the acoustic drive control signals (DRVN) on different piezoelectric elements (20; 20, I; 20, II).

6. The piezoelectric sensor (2) according to any one of the preceding claims, **wherein:** the microcontroller (26) is configured to generate said haptic drive control signals (DRVN, DRVP, DRVEN; DRVEN2, DRVP, DRVEN1, DRVN) and said acoustic drive control signals (DRVN) simultaneously during the interval.

7. The piezoelectric sensor (2) according to any one of the preceding claims, **wherein:** the microcontroller (26) is configured to generate haptic drive control signals (DRVN, DRVP, DRVEN; DRVEN2, DRVP, DRVEN1, DRVN) and/or acoustic drive control signals (DRVN) in response to detecting an electric signal (PZF; PZF1, PZF2) indicating that at least one piezoelectric element (20; 20, I; 20, II) is being bent or has been bent.

8. The piezoelectric sensor (2) according to claim 7, **wherein:** the microcontroller (26) is configured to generate haptic drive control signals (DRVN, DRVP, DRVEN; DRVEN2, DRVP, DRVEN1, DRVN) and/or acoustic drive control signals (DRVN) in response to detecting an electric signal (PZF; PZF1, PZF2) indicating that at least one piezoelectric element (20; 20, I; 20, II) is being bent or has been bent in such a manner that a defined bending threshold is being exceeded or is being undercut.

9. The piezoelectric sensor (2) according to claim 8, **wherein:** the defined bending threshold indicates that a piezoelectric element (20; 20, I; 20, II) is bottoming or about to bottom.

10. The piezoelectric sensor (2) according to claim 8, **wherein:** the defined bending threshold indicates that a piezoelectric element (20; 20, I; 20, II) is being bent but not sufficiently, indicating that the contact pressure or force on a surface that functions as the overlay for the piezoelectric sensor (2) causing the bending of the at least one piezoelectric element (20; 20, I; 20, II), is not sufficiently strong so that the vibration of the at least one piezoelectric element (20; 20, I; 20, II) were usable as haptic feedback. In a such case, the piezoelectric sensor (2) is configured to control generation of audio feedback, preferably via the at least one piezoelectric element (20; 20, I; 20, II).

11. The piezoelectric sensor (2) according to any one of the preceding claims, **wherein:** the microcontroller (26) is configured to adjust the haptic drive control signals (DRVN, DRVP, DRVEN; DRVEN2, DRVP, DRVEN1, DRVN) and/or the acoustic drive control signals (DRVN) in such a manner that the frequency and/or amplitude of the drive voltage (PZ; PZ1, PZ2) is controllable.

12. The piezoelectric sensor (2) according to claim 11, **wherein:** the microcontroller (26) is configured to control the frequency and/or amplitude of the drive voltage (PZ; PZ1, PZ2) in response to state information of the piezoelectric sensor (2).

13. The piezoelectric sensor (2) according to claim 12, **wherein:** the state information indicates whether a bending threshold on a piezoelectric element (20; 20, I; 20, II) is being exceeded, is being undercut, and/or whether bending of a piezoelectric element (20; 20, I; 20, II) is between a defined range.

14. The piezoelectric sensor (2) according to any one of claims 8, 9 or 13, **wherein:** the microcontroller (26) is configured:
i)
- upon exceeding or undercutting a first bending threshold, to start generating audio drive signal for producing audio feedback signal having a first sound level and/or frequency, and
- upon exceeding a second bending threshold that is higher than the first bending threshold, to start generating haptic drive signal for producing haptic feedback signal;
and/or
ii)
to use different thresholds with dedicated feedback signalling for generating both audio signal and vibration signal as modulation functions in respect to bending levels of the at least one piezoelectric sensor element (20; 20, I; 20, II) being responsive to pressure or force exerted on the device surface (10) that functions as overlay to the piezoelectric sensor (2) .

15. The piezoelectric sensor (2) according to any one of the preceding claims, **wherein:** the microcontroller (26) is configured to operate a charge emptying switch (1107) with the acoustic drive control signal (DRVN) to form acoustic drive signal of said at least one piezoelectric sensor element (20; 20, I; 20, II) at activation points (71) as deformations of the haptic drive signal to generate audible vibration of said at least one piezoelectric element in addition to haptic vibration of said at least one piezoelectric sensor element (20; 20, I; 20, II).

16. An apparatus (1) **comprising:** a piezoelectric sensor (2) according to any one of the preceding claims, the apparatus (1) having a surface (10) configured to act as overlay to the piezoelectric sensor (2) in such a manner that pressing on the surface (10), such as by the finger, causes at least one piezoelectric element (20; 20, I; 20, II) to bend and that vibration emitted by the at least one piezoelectric element (20; 20, I; 20, II) in response to the haptic drive control signals cause tactile vibration of the surface (10).

17. Method for simultaneously generating a tactile signal and an acoustic signal with at least one piezoelectric sensor (2) that comprises:
- at least one piezoelectric element (20; 20, I; 20, II) arranged so that it is bendable to produce an electric signal (31, PZ, PZ1, PZ2);
- at least one drive unit (1101) configured to drive the at least one piezoelectric element (20; 20, I; 20, II) to make it vibrate by changing a drive voltage (PZ; PZ1; PZ2) over the piezoelectric sensor element (20; 20, I; 20, II); and
- at least one microcontroller (26) configured:
i) to read electric signals (PZF1; PZF2) indicating bending of said at least one piezoelectric element (20; 20, I; 20, II), and also
ii) to operate the drive unit (1101) on said at least one piezoelectric element (20; 20, I; 20, II) ;
**the method characterized by the step of:** during an interval, the drive unit (1101) is operated on said at least one piezoelectric element (20; 20, I; 20, II) by generating haptic drive control signals (DRVN, DRVP, DRVEN; DRVEN2, DRVP, DRVEN1, DRVN) and acoustic drive control signals (DRVN) in the microcontroller (26), the acoustic drive control signals (DRVN) having a higher frequency but shorter duration than the haptic drive control signals (DRVN), most preferably so that the acoustic drive control signals (DRVN) are used to up- and down-ramp a haptic drive signal over said at least one piezoelectric element (20; 20, I; 20, II) in such a manner that an acoustic signal results from deformations in the haptic drive signal.
